(19) Europäisches Patentamt
European Patent Office
Office européen des brevets

(11) **EP 4 390 424 B1**

(12) **FASCICULE DE BREVET EUROPEEN**

(45) Date de publication et mention de la délivrance du brevet:
**20.08.2025 Bulletin 2025/34**

(21) Numéro de dépôt: **23218246.9**

(22) Date de dépôt: **19.12.2023**

(51) Classification Internationale des Brevets (IPC):
***G01R 31/392*** *(2019.01)*

(52) Classification Coopérative des Brevets (CPC):
**G01R 31/392**

(54) **PROCÉDÉ DE DÉTERMINATION DE L'ÉTAT DE SANTÉ (SOH) D'UNE CELLULE DE BATTERIE LI-ION**

VERFAHREN ZUR BESTIMMUNG DES GESUNDHEITSZUSTANDS (SOH) EINER LI-ION-BATTERIEZELLE

METHOD FOR DETERMINING THE STATE OF HEALTH (SOH) OF A LI-ION BATTERY CELL

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.12.2022 FR 2214102**

(43) Date de publication de la demande:
**26.06.2024 Bulletin 2024/26**

(73) Titulaire: **Commissariat à l'Energie Atomique et aux Energies Alternatives**
**75015 Paris (FR)**

(72) Inventeur: **KLEIN, Jean-Marie**
**38054 GRENOBLE cedex 09 (FR)**

(74) Mandataire: **INNOV-GROUP**
**209 Avenue Berthelot**
**69007 Lyon (FR)**

(56) Documents cités:
EP-B1- 3 080 624    EP-B1- 3 080 625
CN-A- 113 875 067    US-A1- 2014 009 123
US-B1- 10 162 401    US-B2- 9 203 253

**Description**

La présente invention concerne le domaine des batteries Li-ion. Pour le bon fonctionnement des applications pour lesquelles elles sont utilisées, il est essentiel de connaitre la capacité de stockage d'une batterie.

La capacité de stockage électrique d'une batterie se mesure en ampère-heure (Ah), ou en énergie, c'est-à-dire en Watts-heure (Wh). Elle permet de déterminer l'autonomie de la batterie.

L'autonomie d'une batterie dépend de sa capacité de stockage initiale, mais également de son état de santé et de son état de charge.

L'état de santé d'une batterie, ou SOH pour *State Of Health* par anglicisme, qui a trait à l'énergie utilisable en sortie de la batterie, est un pourcentage qui correspond à la quantité d'énergie totale déchargeable dans la batterie à un instant donné, par rapport à la quantité d'énergie totale déchargeable dans la batterie lors de sa fabrication. Ceci permet de prendre en compte l'impact du vieillissement de la batterie sur sa capacité de stockage.

L'état de charge d'une batterie, ou SOC pour *State Of Charge* par anglicisme, est un pourcentage qui correspond à la quantité d'énergie pouvant être déchargée dans la batterie à un instant donné, par rapport à la quantité d'énergie maximale déchargeable dans la batterie audit instant t. Pour une énergie donnée stockée dans la batterie et pouvant être restituée, l'état de charge est donc lié à l'état de santé de la batterie.

Pour autant, selon la présente invention, le calcul du SOC n'est pas obligatoire pour déterminer le SOH d'une batterie, ce qui est particulièrement avantageux et décrit ultérieurement.

L'acceptance de charge est la quantité d'électricité en ampère-heure qu'une batterie avec un état de charge spécifique peut absorber, à une température et à un courant de charge déterminés, et pendant une durée donnée.

La capacité de stockage initiale en énergie restituable d'une batterie est connue et correspond typiquement à un état de santé de 100%. Pour calculer son état de santé à un moment ultérieur, il existe de nombreuses techniques connues.

La plus simple consiste à charger complètement la batterie à un instant t, puis effectuer une décharge complète. La mesure de l'énergie restituée lors de cette décharge complète ramenée à la capacité de stockage initiale de la batterie donne un état de santé fiable. Cependant, outre la perte d'énergie que cette technique implique, le temps nécessaire pour la mettre en œuvre est souvent trop long.

D'autres méthodes ont été développées, par exemple la méthode dite ICA basée sur un calcul de dérivée de la charge sur la tension, décrite notamment dans le brevet EP3080625B1 de la demanderesse et qui fonctionne très bien sur des batteries qui présentent des variations de tension notables, typiquement en pleine charge ou en pleine décharge.

Il existe également une méthode de tension à vide à plusieurs états de charge et calcul mathématique des tensions à vide de chaque électrode, par exemple telle que décrite dans le brevet EP3080624B1 de la demanderesse, mais qui nécessite un temps d'attente dans lequel on laisse la batterie au repos, qui est relativement long pour la mesure des tensions à vide.

Le document US2014/009123A1 divulgue également un procédé de détermination de l'état de santé SOH d'une batterie.

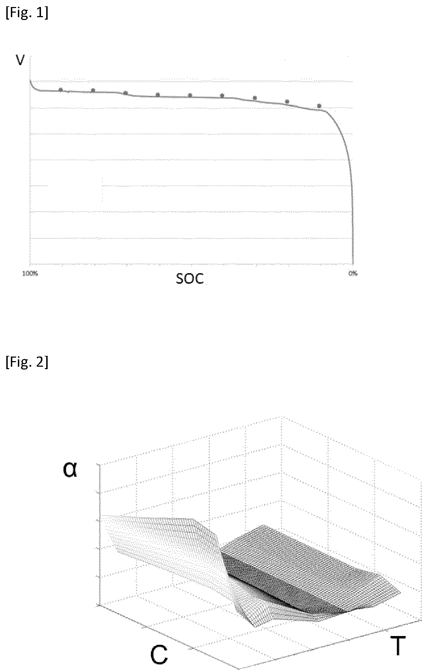

Il est courant que la variation de la tension d'une cellule en fonction du SOC de celle-ci, en charge ou en décharge, présente 3 plages : une plage de forte pente dans les plages de valeurs proches de la pleine charge, une plage de forte pente dans les plages de valeurs proches de la pleine décharge, et une plage de plateau entre ces deux plages extrêmes, comme illustré sur la figure 1.

Sur le plateau, la tension est « relativement constante », c'est-à-dire que la variation de tension aux bornes de la cellule, entre deux mesures successives, est inférieure à une valeur seuil prédéterminée. Ce qui revient à considérer que la pente de la variation de tension est faible, c'est-à-dire inférieure à une valeur seuil prédéterminée.

La présente invention permet de déterminer le SOH d'une cellule, quelle que soit la tension, mais elle est avantageusement mise en œuvre pour des tensions correspondant au plateau de tension.

Elle permet également une mise en œuvre sur une portion réduite du plateau de tension, correspondant à une plage de variation réduite du SOC, et est donc particulièrement applicable dans le contexte d'applications de batteries n'effectuant pas des cycles de charges et décharges complets. Elle est avantageusement mise en œuvre :

    1. pour des batteries connectées au réseau électrique, notamment des batteries mises en œuvre dans le domaine des énergies renouvelables (solaire, éolien, hydraulique, géothermie, biomasse, etc.), et par exemple des batteries d'onduleurs ;
    2. pour des batteries de systèmes autonomes (maisons individuelles / bâtiments autonomes, satellites, dispositifs électroportatifs, etc.).

La présente invention peut être mise en œuvre en charge ou en décharge de la batterie.

De préférence, la charge est contrôlée, réalisée à courant constant et tension constante (CC-CV).

Dans ce contexte, la présente invention concerne selon un premier de ses objets un procédé de détermination de l'état de santé (SOH) d'une cellule de batterie Li-ion, la cellule étant destinée à être opérée dans une plage de tension d'usage pour une application d'usage, le procédé comprenant des étapes consistant à :

- définir une plage de tension de mesure comprise dans la plage de tension d'usage, et délimitée par une première valeur prédéterminée de tension de mesure et une deuxième valeur prédéterminée de tension de mesure, et

- lorsque la tension aux bornes de la cellule est comprise entre la première valeur prédéterminée de tension de mesure et la deuxième valeur prédéterminée de tension de mesure :

- mesurer la valeur de l'intensité aux bornes de la cellule,

- mesurer la valeur de la température de la cellule,

- déterminer l'une des valeurs parmi :

  ○ l'acceptance de charge totale en décharge (Qd-T) sur la plage de tension de mesure ;
  ○ l'acceptance de charge totale en charge (Qc-T) sur la plage de tension de mesure ; l'acceptance de charge totale en décharge (Qd-T), respectivement en charge (Qc-T), étant déterminée par la somme des valeurs Qd (tk), respectivement Qc (tk), entre la première valeur prédéterminée de tension de mesure et la deuxième valeur prédéterminée de tension de mesure, la valeur Qd (tk), respectivement Qc (tk), étant la valeur de l'acceptance de charge en décharge, respectivement en charge, correspondant à la quantité d'Ampère-heure déchargée, respectivement chargée, de la cellule au temps k (tk) ou durant un pas de temps égal à tk ; et

- déterminer l'état de santé (SOH) de la cellule sur la base d'une relation prédéterminée, sur la plage de tension de mesure, entre l'acceptance de charge totale en décharge (Qd-T), respectivement en charge (Qc-T ), et l'état de santé (SOH) de la cellule.

Le procédé de la présente invention est caractérisé en ce que :

- Si la cellule est en décharge, alors la valeur Qd (tk) est déterminée selon la formule Qd (tk) = $\alpha$(T,C) * I(tk) ;

- Si la cellule est en charge, alors la valeur Qc (tk) est déterminée selon la formule Qc (tk) = $\beta$(T,C)* I(tk) ;

Avec $\alpha$(T,C) et $\beta$(T,C) des coefficients dont les valeurs dépendent au moins de la température (T) et éventuellement en outre de l'intensité (C), et qui sont préenregistrées dans une mémoire, I(tk) la valeur du courant au temps k (tk) ou durant un pas de temps égal à tk.

On peut prévoir que la variation de la tension en fonction de l'état de charge (SOC) de la cellule est connue, et dans lequel la plage de tension de mesure est définie, en outre, de sorte à respecter au moins l'un des critères suivants :

- la plage de tension de mesure est choisie de sorte que la variation de la tension en fonction de l'état de charge (SOC) de la cellule est inférieure à une valeur seuil prédéfinie,

- la plage de tension de mesure est comprise dans une plage représentative d'un état de charge (SOC) de la cellule compris entre 10% et 90%, et préférentiellement compris entre 45% et 55%, et

- la plage de tension de mesure est choisie dans une plage de tension traversée par la cellule dans le cadre de son application d'usage à une fréquence supérieure ou égale à une valeur seuil prédéterminée.

On peut prévoir que dans la plage de tension de mesure, l'écart entre la première valeur prédéterminée de tension de mesure et la deuxième valeur prédéterminée de tension de mesure est compris entre 0,05V et 0,20V, et préférentiellement entre 0,05V et 0,10V.

On peut prévoir en outre une étape d'essais, préalablement à l'étape de détermination de l'état de santé (SOH) de la cellule sur la base d'une relation prédéterminée, sur la plage de tension de mesure, entre l'acceptance de charge totale en décharge (Qd-T), respectivement en charge (Qc-T ), et l'état de santé (SOH) de la cellule, lesdits essais étant mis en œuvre sur une cellule représentative pour déterminer ladite relation entre l'état de santé (SOH) de la cellule et l'acceptance de charge totale en décharge (Qd-T), respectivement en charge (Qc-T ).

On peut prévoir en outre une étape de calibration de la capacité totale de la cellule de batterie Li-ion, ladite cellule étant caractérisée par une capacité initiale Ctot_ref (t0),

l'étape de calibration comprenant des étapes consistant à :

- détecter une phase de fin de charge, respectivement de décharge, et lors de la détection d'une phase de fin de charge, respectivement de décharge :

- recalibrer la capacité totale de la cellule comme étant Ctot_ref (tk)=SOH* Ctot_ref (t0) ; et définir Cr (tk)= Ctot_ref (tk), respectivement Cr (tk)= 0 ; et

- Définir les valeurs Qd (tk) = Qc (tk) = 0,

avec

Ctot_ref (t0) : la valeur de la capacité de stockage totale de la cellule considérant une décharge complète dans les conditions de référence, au temps initial (t0),

Ctot_ref (tk) : la valeur de la capacité de stockage totale de la cellule considérant une décharge complète dans les conditions de référence, au temps k (tk) ou durant un pas de temps égal à tk,

Cr (tk) : la capacité stockée restante considérant une décharge complète dans les conditions de référence, au temps k (tk) ou durant un pas de temps égal à tk, et

SOH : la valeur de l'état de santé (SOH) déterminé de la cellule.

On peut prévoir en outre une étape de détermination de l'état de charge (SOC) de la cellule, par des étapes consistant à déterminer l'une des valeurs parmi :

○ la valeur Qd (tk), la valeur de l'acceptance de charge correspondant à la quantité d'Ampère-heure déchargée de la cellule au temps k (tk), ou durant un pas de temps égal à tk ; et calculer la valeur Cr (tk), la capacité stockée restante considérant une décharge complète dans les conditions de référence, au temps k (tk) telle que Cr (tk) = Cr (tk-1) - Qd (tk) ;

○ la valeur Qc (tk), la valeur de l'acceptance de charge correspondant à la quantité d'Ampère-heure chargée au temps k (tk), ou durant un pas de temps égal à tk ; et calculer la valeur Cr (tk) au temps k (tk) telle que Cr (tk) = Cr (tk-1) + Qc (tk).

On peut prévoir en outre une étape d'initialisation, comprenant des étapes consistant à :

- déterminer la valeur d'une constante Ctot_ref (t0), correspondant à la capacité de stockage totale de la cellule à un temps initial (t0), considérant une décharge complète dans les conditions de référence ;

- initialiser la valeur d'une variable Ctot_ref (tk), correspondant à la capacité de stockage totale de la cellule à un temps k ultérieur (tk), considérant une décharge complète dans les conditions de référence, telle que Ctot_ref (tk) = Ctot_ref (t0) ;

- déterminer la valeur de l'état de charge (SOC) de la cellule ;

- initialiser la valeur d'une variable Cr (tk), correspondant à la capacité stockée restante au temps k (tk), en fonction de la valeur de l'état de charge (SOC), telle que :

Cr (tk) = 0, si l'état de charge (SOC) déterminé est égal à 0% ;

Cr (tk) = Ctot_ref (tk), si l'état de charge (SOC) déterminé est égal à 100% ; et

Cr (tk) = X, si l'état de charge (SOC) déterminé est égal à X/ Ctot_ref (tk).

- Initialiser à 0 la valeur d'une variable Qd (tk), correspondant à l'acceptance de charge en décharge de la cellule, et

- Initialiser à 0 la valeur d'une variable Qc (tk), correspondant à l'acceptance de charge en charge de la cellule.

On peut prévoir en outre des étapes consistant à :

- mesurer la valeur du courant (I) aux bornes de la cellule ;

- comparer la valeur du courant (I) mesurée à une valeur de référence (Iref) éventuellement non nulle ;

- déterminer le mode de charge de la cellule, tel que :

○ Si I < Iref, alors la cellule est en mode de décharge ;

○ Si I > Iref, alors la cellule est en mode de charge ;

○ Si I = Iref pendant une durée prédéterminée, alors la cellule est en mode neutre.

On peut prévoir en outre des étapes consistant à :

○ Si la cellule est en mode de décharge, alors déterminer la valeur Qd (tk), et calculer la valeur Cr (tk) ;
○ Si la cellule est en mode de charge, alors déterminer la valeur Qc (tk), et calculer la valeur Cr (tk).

On peut prévoir que :

- Si la cellule est en mode de décharge, alors la valeur Qd (tk) est déterminée selon la formule Qd (tk) = $\alpha$(T, C) * I(tk) ; et

- Si la cellule est en mode de charge, alors la valeur Qc (tk) est déterminée selon la formule Qc (tk) = $\beta$(T, C)* I(tk) ;

$\alpha$(T, C) et $\beta$(T, C) étant des coefficients dont les valeurs enregistrées dans une mémoire, dépendant au moins de la température (T) et éventuellement de l'intensité (C).

On peut prévoir que le procédé selon l'invention est mis en œuvre dans la plage de tension d'usage dans laquelle la cellule est destinée à être opérée, et qui est comprise entre une première valeur prédéterminée correspondant un état de charge (SOC) supérieur ou égal 10% ; et une deuxième valeur prédéterminée correspondant à un état de charge (SOC) inférieur ou égal à 90%.

Selon un autre de ses objets, l'invention concerne également un programme d'ordinateur, comprenant des instructions de code de programme pour la mise en œuvre du procédé selon l'invention lorsque ledit programme est exécuté sur un ordinateur.

L'invention concerne également un système de gestion de batterie, comprenant un processeur configuré pour pouvoir exécuter le programme d'ordinateur selon l'invention.

D'autres caractéristiques et avantages de la présente invention apparaîtront plus clairement à la lecture de la description suivante donnée à titre d'exemple illustratif et non limitatif et faite en référence aux figures annexées.

Les figures ne sont pas nécessairement à l'échelle.

DESCRIPTIF DES DESSINS

[Fig. 1] illustre la variation de tension en fonction de l'état de charge pour une batterie Li-ion,

[Fig. 2] illustre un mode de réalisation d'un modèle de valeurs de coefficient $\alpha$ selon l'invention, en fonction de l'intensité (régime) et de la température,

[Fig. 3] illustre un mode de réalisation d'un modèle de valeurs de la capacité déchargée Cr selon l'invention, en fonction de l'intensité (régime) et de la température,

[Fig. 4] illustre un mode de réalisation d'un modèle de valeurs de coefficient $\beta$ selon l'invention, en fonction de l'intensité (régime) et de la température,

[Fig. 5] illustre un mode de réalisation d'un modèle de valeurs de la capacité chargée Cr selon l'invention, en fonction de l'intensité (régime) et de la température,

[Fig. 6] illustre un modèle de variation du SOH en fonction de l'acceptance de charge Q selon l'invention.

**Description détaillée**

La présente invention a notamment vocation à être mise en œuvre dans un système de gestion de batterie, connu sous l'acronyme BMS pour *Battery Management System* par anglicisme. Elle comprend un algorithme mis en œuvre sous forme de programme d'ordinateur.

Par simplification, on entend ici indistinctement les termes « batterie » et « cellule ».

L'invention vise à la détermination de l'état de santé (SOH) d'une batterie, au travers de la mesure de son acceptance de charge, ou de décharge, totale entre deux valeurs de tensions prédéterminées.

Cette mesure d'acceptance de charge ou de décharge totale peut être effectuée en dehors de tout contexte de calcul du SOC de la batterie, la détermination de l'état de santé (SOH) d'une batterie selon l'invention n'étant pas influencé par le SOC.

La détermination de l'état de santé (SOH) pouvant être intégré au sein du BMS, elle peut cependant s'effectuer en parallèle et complément des fonctions de calcul du SOC implémentées dans le BMS.

A ce titre, le mode de réalisation décrit ci-dessous comprendra également la description des calculs du SOC. De manière classique, le calcul du SOC d'une batterie nécessite une première initialisation à un temps initial t0 permettant de définir certaines valeurs permanentes, non modifiables, l'initialisation permettant d'alimenter ensuite une boucle de calcul de SOC et de calibration éventuelle.

Le SOC d'une batterie indique son état de charge, c'est-à-dire le pourcentage que représente la capacité de stockage restante de la batterie par rapport à la capacité de stockage totale restituable à l'instant t.

Le SOH d'une batterie indique son état de santé, c'est-à-dire le niveau de vieillissement de la batterie, généralement exprimé en pourcentage de la capacité de stockage totale initiale.

La capacité de stockage est exprimée en Ah et de manière analogue l'énergie de stockage est exprimée en Wh.

**Première initialisation pour le calcul du SOC**

On considère par t0 l'instant de première initialisation de l'algorithme selon l'invention.

On détermine tout d'abord la valeur $C_{tot\_ref}(t_0)$, qui est la capacité de stockage initiale de la cellule. Cette valeur est connue ou mesurée, par exemple en usine. Par exemple, elle est égale à 2,5 Ah.

On détermine ensuite au temps $t_k$ la valeur $C_{tot\_ref}(t_k)$, qui est la capacité de stockage totale au temps $t_k$ de ladite cellule, telle que $C_{tot\_ref}(t_k) = C_{tot\_ref}(t_0)$, dans l'hypothèse d'un démarrage avec un SOH = 100% lors du premier démarrage du système dans son application de destination. Par « démarrage », on entend le moment où on initialise le BMS et donc le moment de premier usage de la batterie avec ce BMS. Typiquement, il s'agit du premier usage de la batterie après commercialisation. Dans le cas d'une batterie de seconde vie, cela peut être différent.

On peut alors initialiser la valeur de $C_r(t_k)$, la capacité stockée restante au temps $t_k$, selon l'un des 3 cas suivants :

- $C_r(t_k) = 0$, avec un démarrage avec un SOC = 0%, par exemple quand on sait la batterie totalement déchargée ;
- $C_r(t_k) = C_{tot\_ref}(t_k)$, avec un démarrage avec un SOC = 100%, par exemple quand on sait la batterie totalement chargée ; et

- $C_r(t_k) = X$, avec un démarrage avec un SOC = $X/C_{tot\_ref}(t_k)$.

Avec en l'espèce $t_k = t_0$ si SOH = 100%.

La valeur $C_r(t_k)$ peut être initialisée de ces 3 manières différentes, en fonction de la valeur du SOC. Il y a de fortes chances pour que la batterie soit entièrement chargée avant installation dans son application de destination. Dans ce cas, la valeur de $C_r(t_k)$ est initialisée à $C_{tot\_ref}(t_k)$, correspondant à un SOC de 100%. Mais si la valeur du SOC est inconnue, on peut l'initialiser à une valeur prédéterminée, par exemple à 75%, et attendre l'obtention d'une pleine charge avant de le réétalonner à 100%.

Enfin, on détermine la valeur $Q_d(t_k)$, la quantité d'Ah déchargée au temps $t_k$, qui est en l'espèce égale à $Q_c(t_k)$, la quantité d'Ah chargée au temps $t_k$, initialisée à 0 puisque la batterie n'est à ce stade $t_0$ ni en charge ni en décharge.

Au moins la valeur initiale $C_{tot\_ref}(t_0)$ est enregistrée dans une mémoire. On peut aussi enregistrer la valeur $C_r(t_0)$. La valeur $C_{tot\_ref}(t_0)$ est essentielle puisqu'elle a un impact direct sur la valeur du SOC, donc un impact direct sur la gestion de l'énergie, primordiale pour éviter un vieillissement trop accéléré de la batterie.

Les valeurs de $C_{tot\_ref}(t_0)$, $C_{tot\_ref}(t_k)$, $C_r(t_k)$, $Q_d(t_k)$, $Q_c(t_k)$, peuvent également être enregistrées dans une mémoire.

## Calibration du calcul du SOC

On peut prévoir une étape de calibration.

L'étape de calibration peut être mise en œuvre à tout moment. Elle s'appuie de préférence sur une détermination préalable du SOH selon l'invention, décrit ultérieurement.

Une fois la détermination du SOH$(t_k)$ au temps $t_k$ effectuée selon l'invention, il est possible de recalibrer le calcul du SOC de la façon suivante :

- On calcule

$$C_{tot\_ref}(t_k) = SOH(t_k) * C_{tot\_ref}(t_0).$$

Si le BMS détecte une fin de décharge, alors on considère que $C_r(t_k) = 0$.

- Si le BMS détecte une fin de charge, alors on considère que $C_r(t_k) = C_{tot\_ref}(t_k)$.
- On peut alors recalculer le SOC$(t_k)$ tel que SOC$(t_k) = Cr(t_k)/ C_{tot\_ref}(t_k)$

On peut alors calibrer la valeur $Q_d(t_k) = Q_c(t_k) = 0$.

La quantité d'Ah déchargée au temps $t_k$ est égale à la quantité d'Ah chargée au temps $t_k$, calibrée à 0, ce qui termine l'étape de calibration.

Dans cette phase de calibration, le SOC est recalibré à 100%, respectivement 0%, à chaque fois que le critère de fin de charge, respectivement de fin de décharge, est atteint par le BMS, ce qui permet à chaque fois que c'est possible de corriger les éventuelles dérives d'un algorithme Ah-métrique.

## Mode de charge de la batterie

On prévoit de déterminer le mode de charge de la batterie, c'est-à-dire si celle-ci est en charge, en décharge, ou ni l'un ni l'autre, c'est-à-dire en mode neutre.

Pour ce faire, on prévoit de mesurer l'intensité I aux bornes de la batterie.

Si $I < I_{ref}$, alors on considère que la batterie est en mode de décharge ;

Si $I > I_{ref}$, alors on considère que la batterie est en mode de charge ;

Si $I = I_{ref}$ pendant une durée prédéterminée, alors on considère que la batterie est en mode neutre.

$I_{ref}$ est une valeur de référence d'intensité. Par exemple $I_{ref} = 0$. Toutefois, il peut être souhaitable de définir une valeur non nulle pour $I_{ref}$, afin de prendre en compte notamment le courant lié à l'autoconsommation du système intégrant la batterie, qui est généralement en veille lors de la mise en œuvre de l'invention.

## Calcul du SOC

Une fois le mode de charge de la batterie déterminé, on peut calculer le SOC de la manière suivante.

*Pour le mode de décharge :*

On détermine tout d'abord la valeur $Q_d(t_k)$, la quantité d'Ampères-heure déchargée au temps $t_k$, ou durant un pas de temps égal à $t_k$. La quantité d'Ah peut être mesurée ou calculée, par intégration du courant en fonction du temps.

En particulier, la valeur $Q_d(t_k)$ est calculée en fonction de la température, et de l'intensité de décharge, comme décrit ultérieurement.

On peut alors calculer la valeur $C_r(t_k)$, qui est la capacité stockée restante, considérant une décharge complète dans les conditions de référence.

La valeur $C_r(t_k)$ au temps $t_k$ dépend :

- de la valeur $C_r(t_{k-1})$ au pas de temps précédent $t_{k-1}$, et
- de la valeur $Q_d(t_k)$.

En l'espèce, on prévoit de calculer la valeur $C_r(t_k)$ selon l'équation suivante :

$$C_r\,(t_k) = C_r\,(t_{k-1}) - Q_d\,(t_k).$$

La valeur $Q_d\,(t_k)$ est retranchée de la valeur $C_r\,(t_{k-1})$ puisque la batterie est en mode décharge.

En fonction des besoins, on peut enregistrer dans une mémoire au moins une des valeurs $Q_d\,(t_k)$, voire toutes les valeurs $Q_d\,(t_k)$ à chaque $t_k$.

On peut aussi écraser la valeur $Q_d\,(t_{k-1})$ par celle de $Q_d\,(t_k)$.

On peut enfin remettre à 0 la valeur $Q_d\,(t_k)$.

Dans certains cas, il peut arriver que $C_r\,(t_k) = 0$ avant que le critère de fin de décharge du BMS ne soit atteint. Dans ce cas, il est possible :

- soit indiquer un SOC stabilisé à 0% tout en continuant d'intégrer les Ah jusqu'à l'obtention du critère de fin de décharge ;
- soit d'indiquer un SOC < 0%.

Avantageusement, le critère de fin de décharge est un moment privilégié pour déclencher une éventuelle calibration du SOC. En l'espèce, la calibration est préférentiellement mise en œuvre à SOC=0%.

*Pour le mode de charge :*

On calcule tout d'abord la valeur $Q_c\,(t_k)$, la quantité d'Ampères-heure chargée au temps $t_k$, ou durant un pas de temps égal à $t_k$.

En particulier, la valeur $Q_c\,(t_k)$ est calculée en fonction de la température, et éventuellement de l'intensité, comme décrit ultérieurement.

On peut alors calculer la valeur $C_r\,(t_k)$, qui est la capacité stockée restante, considérant une décharge complète dans les conditions de référence.

La valeur $C_r\,(t_k)$ au temps $t_k$ dépend :

- de la valeur $C_r\,(t_{k-1})$ au pas de temps précédent $t_{k-1}$, et
- de la valeur $Q_c\,(t_k)$.

En l'espèce, on prévoit de calculer la valeur $C_r\,(t_k)$ selon l'équation suivante :

$$C_r\,(t_k) = C_r\,(t_{k-1}) + Q_c\,(t_k).$$

La valeur $Q_c\,(t_k)$ est ajoutée à la valeur $C_r\,(t_{k-1})$ puisque la batterie est en mode de charge.

En fonction des besoins, on peut enregistrer dans une mémoire au moins une des valeurs $Q_c\,(t_k)$, voire toutes les valeurs $Q_c\,(t_k)$ à chaque $t_k$.

On peut aussi écraser la valeur $Q_c\,(t_{k-1})$ par celle de $Q_c\,(t_k)$.

On peut enfin remettre à 0 la valeur $Q_c\,(t_k)$.

Dans certains cas, il peut arriver que $C_r\,(t_k) >$ $C_{tot\_ref}\,(t_k)$, et ce, avant que le critère de fin de charge du BMS ne soit atteint. Dans ce cas, il est possible :

- soit indiquer un SOC stabilisé à 100% tout en continuant d'intégrer les Ah jusqu'à l'obtention du critère de fin de charge ;
- soit d'indiquer un SOC supérieur à 100%.

Avantageusement, le critère de fin de charge est un moment privilégié pour déclencher une éventuelle calibration du SOC. En l'espèce, la calibration est préférentiellement mise en œuvre à SOC=100%.

A tout moment $t_k$ du fonctionnement d'une batterie, on peut calculer son état de charge SOC selon l'équation suivante :

$$SOC\,(t_k) = 100 * C_r\,(t_k)\,/\,C_{tot\_ref}\,(t_k)$$

### Acceptance de charge

A chaque pas de mesure $t_k$, correspondant au pas de temps considéré, on calcule la valeur de l'acceptance de charge, $Q_d$ en décharge ou $Q_c$ en charge, en Ah.

Le calcul de l'acceptance de charge peut être mis en œuvre par intégration selon le temps de la mesure du courant, de l'intensité, entre deux tensions prédéfinies, qui nécessitent typiquement plusieurs pas de temps $t_k$.

En fait, pour une charge (ou une décharge), la valeur de l'acceptance de charge, également appelée capacité de charge (ou de décharge) dépend notamment de la température, mais aussi de l'intensité chargée (ou déchargée).

Il apparait donc astucieux de prendre en compte au moins l'influence de la température, et éventuellement de l'intensité, dans le calcul de l'acceptance de charge.

A cet effet, on prévoit d'affecter un coefficient à la mesure du courant.

Ce coefficient, appelé « β » en charge et « α » en décharge, est en l'espèce non linéaire, comme décrit ci-dessous.

### Impact de la température

En pratique l'intensité du courant et la température changent et l'un et l'autre ont un impact sur la mesure des Ah chargés ou déchargés.

Il est donc nécessaire d'établir un courant et une température de référence.

L'intensité du courant est mesurée aux bornes de la batterie. La température est celle du cœur de la cellule, qui est approximée par la température de peau, par exemple obtenue grâce à un thermocouple fixé sur la paroi de la cellule de la batterie.

A chaque pas de temps, et en l'espèce en temps réel, on mesure l'intensité du courant, la tension aux bornes de la batterie, et la température de peau.

La température d'une cellule a un impact sur la capacité de stockage de celle-ci. Par exemple, pour une décharge à 25 °C, on mesure une capacité de 10 Ah. Mais si on effectue la décharge de la même cellule à -20°C, alors la mesure de la capacité est différente, en l'espèce inférieure, et par exemple de 1 Ah.

Il convient donc d'établir une valeur de température de référence.

En pratique, puisque la valeur de la température varie au cours des mesures de courant, il convient de ramener la valeur de la température mesurée (variable) à la valeur de la température de référence (constante), en l'espèce grâce à une matrice de référence qui permet d'appliquer un facteur multiplicatif à chaque mesure, ci-après le coefficient $\alpha$ ou $\beta$, dont la valeur dépend de la température.

De manière connue, le régime C, ou *C-rate* par anglicisme, est une intensité qui est l'appel de courant fait sur la batterie. 1C correspond à une décharge de la batterie en 1h.

Avec une batterie de 10Ah, une décharge à 1C signifie que la batterie peut être déchargée à 10A ; une décharge à C/10 signifie que la batterie peut être déchargée à 1A ; une décharge à 10C signifie que la batterie peut être déchargée à 100A ; etc.

Le régime est donc une façon de noter une intensité ou courant électrique. Par simplification, les notions de régime, d'intensité et de courant sont donc utilisées ici de façon interchangeable.

En l'espèce, les valeurs de régime de courant sont comprises entre C/20 et 3C, qui correspondent aux valeurs entre lesquelles une batterie Li-ion peut cycler.

Dans le cas présent, on multiplie la valeur de l'intensité mesurée, ou des ampère-heure mesurés, par un coefficient $\alpha$ ou $\beta$, dont la valeur dépend de la valeur de la température mesurée et qui peut dépendre également de la valeur du courant mesuré. Le coefficient $\alpha$ ou $\beta$ permet d'établir une équivalence avec les valeurs de la température et du courant de référence.

En l'espèce, on a une table de référence pour la charge (coefficient $\beta$) et une table de référence pour la décharge (coefficient $\alpha$), de préférence entre une température supérieure à -20°C et inférieure à +70°C, qui sont les valeurs d'usage de la température d'une batterie Li-ion.

Dans le cas de la décharge de la batterie, liée à un usage, le courant déchargé est généralement de nature variable. Pour cette raison, on utilisera pour la décharge un coefficient $\alpha$ dont la valeur dépend de la valeur de la température mesurée et de la valeur du courant mesuré.

La charge d'une batterie Li-ion s'effectuant généralement à courant constant et prédéterminé sur une grande partie de sa plage de SOC (hors zone de fin de charge, typiquement SOC>90%), le calcul de l'acceptance de charge sur cette plage peut être simplifié par l'application d'un coefficient $\beta$ dont la valeur dépend uniquement de la température (la valeur du courant étant connue et fixe).

En environnement thermalisé, la conversation en température n'est pas obligatoire. De même si le courant de charge ou de décharge est imposé. Dans ce cas, on met en œuvre un seul facteur de correction, c'est-à-dire une seule valeur de coefficient.

Dans le cas du calcul de SOC, on calcule à chaque pas de temps $t_k$ la quantité d'Ah qui a transité, ce qui permet la mise à jour du SOC à chaque pas de temps.

Alternativement, pour le calcul du SOC, il est possible de sommer sur plusieurs pas de temps $t_k$ l'acceptance de charge, en charge ou en décharge, et de ne calculer le SOC comme décrit précédemment que tous les N pas de temps, pour N entier naturel >1, ou lorsque cela est nécessaire pour le système.

Les calculs précédents permettent ainsi au système BMS de calculer à tout moment $t_k$ le SOC de la batterie.

## Plage de tension d'usage et plage de tension de mesure pour le calcul du SOH

Il est intéressant de pouvoir corriger la mesure du SOC en intégrant une détermination de l'état de santé (SOH) de la batterie lors de l'étape de calibration décrite précédemment.

Cette détermination du SOH permet la prise en compte du vieillissement batterie dans l'estimation à tout moment du $SOC(t_k)$ selon le calcul précédent, ainsi que de la capacité restante de la batterie $C_{tot\_ref}(t_k)$.

La prise en compte du vieillissement batterie dans le $C_{tot\_ref}(t_k)$ permet également de corriger toute mesure de SOC effectuée par d'autres modes d'estimation ne prenant pas en compte la baisse progressive au cours du temps de la capacité générale de la batterie. Ceci peut être une estimation du SOC fournie par un BMS n'implémentant pas le mode de calcul décrit précédemment, en particulier l'étape de calibration décrite précédemment.

La connaissance du $C_{tot\_ref}(t_k)$ fournissant une information importante à l'utilisateur sur la capacité maximale de la batterie à restituer de l'énergie, et donc à fournir un service, la détermination du $C_{tot\_ref}(t_k)$ est également d'intérêt pour l'utilisateur hors de tout contexte de calcul de l'état de charge (SOC) décrit précédemment.

Enfin, l'état de santé (SOH) de la batterie peut être un critère important pour l'utilisateur afin de déterminer le moment où un vieillissement trop poussé de la batterie nécessitera son remplacement. Par exemple, une batterie de SOH<80% pourra ainsi être considérée comme à remplacer. Ceci ne nécessitant alors aucun calcul de $C_{tot\_ref}(t_k)$ ou de SOC(tk).

Il est donc proposé ici un mode de détermination du SOH d'une batterie. Avantageusement, les calculs du $C_{tot\_ref}(t_k)$, et et du SOC décrits précédemment peuvent en outre être mis en œuvre.

**SOH**

Le calcul du SOH selon l'invention s'effectue entre deux valeurs prédéterminées de tensions.

Pour ce faire, on définit comme plage de tension d'usage la plage de tension utilisée par la batterie dans son application.

Au sein de cette plage de tension d'usage, un définit une plage de tension de mesure s'étendant entre une première valeur prédéterminée de tension de mesure et une deuxième valeur prédéterminée de tension de mesure.

La plage de tension de mesure est choisie comme étant régulièrement parcourue intégralement par la batterie, lors d'une phase de charge et/ou de décharge. On entend par « régulièrement » le fait qu'elle soit parcourue intégralement à une fréquence égale et préférentiellement supérieure à la fréquence souhaitée d'évaluation du SOH.

De préférence, les deux valeurs prédéterminées de tensions de mesure sont comprises dans le plateau de tension de la batterie, et typiquement incluses dans un intervalle équivalent de SOC compris entre 10% et 90%.

Afin d'assurer une mesure régulière, on choisit ici les deux valeurs prédéterminées de tensions de mesure comme étant proches d'un équivalent de 50% du SOC de la batterie, par exemple entre 40% et 60% du SOC.

De façon préférentielle, l'intervalle de tension entre les deux valeurs prédéterminées de tensions de mesure est d'amplitude limitée, afin d'assurer un parcours complet et rapide de celui-ci lors d'une charge ou décharge et donc une évaluation rapide du SOH.

Si la plage de tension de mesure est trop petite, par exemple inférieure à 0,05V, le risque est de générer trop d'erreurs dans l'évaluation du SOH. Si la plage de tension de mesure est trop grande, par exemple supérieure à 0,20V, le risque est que le temps de détermination du SOH soit trop long.

Il est ainsi choisi entre 0,05V à 0,20V, et préférentiellement entre 0,5V et 0,10V. Des essais ont été réalisée par la demanderesse avec un pas de mesure de 0,05V, aboutissant à des résultats de mesure en une vingtaine de secondes.

Dans le cas présent, les deux valeurs prédéterminées de tensions de mesure sont de 3,2V et 3,25V, soit une plage de tension de mesure de 0,05V proche d'un équivalent de 50% du SOC d'une batterie LFP.

La détermination du SOH peut avantageusement prendre place lors d'un usage normal de la batterie, sans perturber ledit usage, lorsque la tension de celle-ci parcourt en charge et/ou en décharge la plage de tension de mesure. Dans le cas d'un système effectuant également un calcul du SOC, la détermination du SOH peut se faire en parallèle de la détermination du SOC.

La détermination du SOH s'effectue à l'occasion, et à l'issue, du parcours en charge ou en décharge entre la première valeur prédéterminée de tension de mesure et la deuxième valeur prédéterminée de tension de mesure.

Durant le parcours de la plage de tension de mesure, on calcule l'acceptance de charge, en charge ou en décharge, entre ces deux tensions prédéterminées. Pour cela, on calcule à chaque pas de temps $t_k$ la quantité d'Ah qui a transité, et on somme cette quantité sur l'ensemble des pas de temps $t_k$ entre les deux tensions prédéterminées, c'est-à-dire en l'espèce pendant 0,05V, entre 3,2V et 3,25V.

**Acceptance de charge totale**

La détermination de l'acceptance de charge entre les deux tensions de mesure est effectuée selon la même approche que celle présentée précédemment pour le calcul du SOC, c'est-à-dire :

- en mesurant à chaque pas de temps $t_k$ l'intensité du courant chargé ou déchargé, ainsi que la température de la batterie,
- en calculant la quantité d'Ah qui a transité sur le pas de temps $t_k$.

Les quantités d'Ah qui ont transitées sont sommées sur l'ensemble de la plage de tension de mesure afin d'obtenir l'acceptance de charge totale, en charge ou en décharge, sur celle-ci.

On notera ici $Q_{d-T}$ et $Q_{c-T}$ les acceptances de charge totales, en décharge ou en charge respectivement, issues de la sommes des $Q_d(t_k)$ et $Q_c(t_k)$ respectives, issues des différents pas de temps $t_k$ nécessaires au parcours de la plage de tension de mesure.

Lors du calcul de la quantité d'Ah qui a transité, le courant mesuré est corrigé en courant et température comme dans le calcul du SOC décrit précédemment. Connaissant le régime, par mesure du courant qui transite, et la température, grâce à la table de référence correspondant au mode de charge ou de décharge, il est possible de compenser en température et en intensité, c'est-à-dire d'appliquer à la mesure de l'intensité I, la valeur appropriée du coefficient $\alpha$ ou $\beta$.

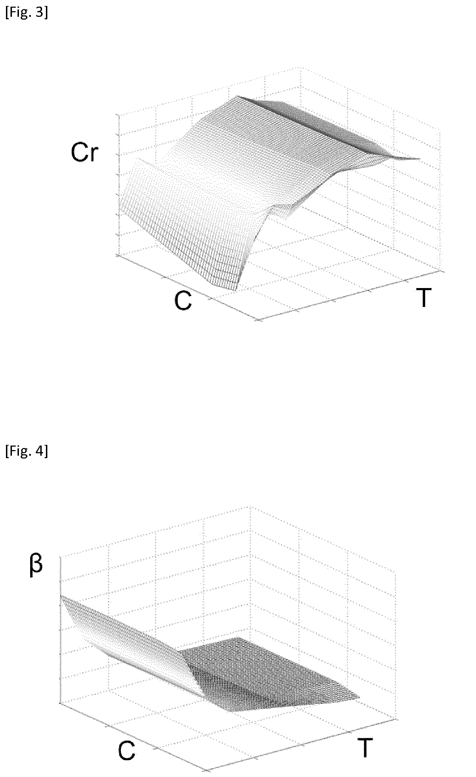

Par exemple, la figure 2 ou la figure 4 peut aussi se présenter sous forme de tableau. Par exemple, la valeur de la température de référence est de 25°C à un régime C/2. Dans ces conditions, $\alpha = 1$.

Pour toute autre condition, la valeur du coefficient $\alpha$ est donnée par la température couplée au régime. De même pour le coefficient $\beta$.

Par exemple, si la température est de 10°C et au même régime C/2 alors $\alpha = 1.051$. Si la température est de 30°C et le régime égal à 2C, alors $\alpha = 1.012$ ; etc.

L'utilisation de coefficients de correction $\alpha$ et $\beta$ permet de prendre en compte l'influence du régime de courant et les effets de la température, à la fois en décharge ($\alpha$) et en charge ($\beta$). Grace à ces coefficients, chaque Ah chargé et déchargé est rapporté à une capacité de référence fixe.

## Détermination du SOH

L'étape précédente de parcours de la plage de tension de mesure en charge ou décharge a permis de déterminer l'acceptance de charge totale, en charge ou en décharge, sur la plage de tension de mesure : $Q_{d-T}$ ou $Q_{c-T}$

Il a été remarqué par la demanderesse que l'acceptance de charge ou de décharge sur une plage de tension prédéterminée d'une batterie était représentative de l'état de santé (SOH) de celle-ci.

Au travers d'une campagne de mesures préalables sur des batteries représentatives de celles utilisées dans l'application, il est donc possible de déterminer une relation de correspondance entre l'acceptance de charge sur la plage de tension de mesure, en charge ou en décharge, et l'état de santé (SOH) de la batterie.

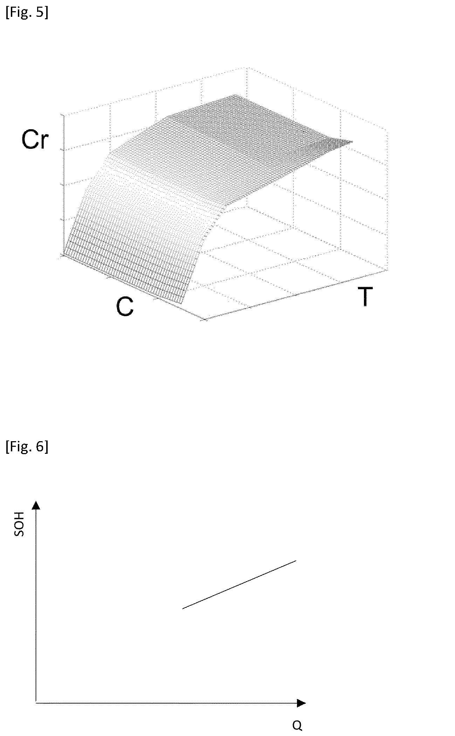

Suite à une telle campagne d'essai, on peut par exemple prévoir d'enregistrer dans une mémoire une abaque prédéfinie entre la valeur du SOH et l'acceptance de charge, en l'espèce sous forme de droite, comme illustré sur la figure 6.

Cette relation peut également être de nature analytique, soit une formule de calcul, et implémentée dans une mémoire du BMS.

En reportant la valeur de l'acceptance de charge totale $Q_{d-T}$ ou $Q_{c-T}$ calculée précédemment, on peut ainsi déterminer la valeur du SOH.

L'invention n'est pas limitée aux modes de réalisation précédent décrits.

L'échantillonnage des mesures, c'est-à-dire la valeur du pas de temps $t_k$, peut être réévalué en fonction de la précision attendue.

Les cartographies $\alpha$ et $\beta$ peuvent être ajustées en fonction des critères de fin de charge et de fin de décharge définis par le BMS.

Dans le cas d'un module de batterie comprenant plusieurs éléments en série et plusieurs thermocouples, il est préférable de sélectionner la plus faible température, afin d'établir un diagnostic basé sur les conditions les plus limitantes.

## Nomenclature

Données d'entrée

$U_{low\ end}$ : Tension de fin de décharge

$\alpha$ : Coefficient permettant de prendre en compte l'impact au moins de la température sur la décharge

$\beta$ : Coefficient permettant de prendre en compte l'impact au moins de la température sur la charge

$C_{tot\_ref}(t_0)$ : Capacité de stockage initiale, fixée en phase d'initialisation et modifiée une fois par la valeur calculée lors du premier contrôle réussi, le contrôle étant une première pleine charge ou pleine décharge permettant de valider par la mesure que la valeur $C_{tot\_ref}(t_k)$ et bien égale au démarrage à la valeur $C_{tot\_ref}(t_0)$.

Valeurs mesurées

I : Courant aux bornes de la cellule

T : Température de peau de la cellule

U : Tension aux bornes de la cellule

Valeurs calculées

$C_r(t_k)$ : Capacité stockée restante, considérant une décharge complète dans les conditions de référence

$C_{tot\_ref}(t_k)$ : Capacité de stockage totale considérant une décharge complète dans les conditions de référence

$Q_d(t_k)$ : acceptance de charge en décharge, quantité d'Ah déchargée au temps $t_k$, durant un pas de temps égal à $t_k$ pour la fonction SOC

$Q_c(t_k)$ : acceptance de charge en charge, quantité d'Ah chargée au temps $t_k$, durant un pas de temps égal à $t_k$ pour la fonction SOC

$Q_{d-T}$ : acceptance de charge totale sur la plage de tension de mesure, en décharge

$Q_{c-T}$ : acceptance de charge totale sur la plage de tension de mesure, en charge

SOC $(t_k)$ : Etat de charge de la cellule au temps $t_k$

SOH $(t_k)$ : Etat de santé de la cellule au temps $t_k$

## Revendications

1. Procédé de détermination de l'état de santé (SOH) d'une cellule de batterie Li-ion, la cellule étant destinée à être opérée dans une plage de tension d'usage pour une application d'usage, le procédé comprenant des étapes consistant à :

   - définir une plage de tension de mesure comprise dans la plage de tension d'usage, et délimitée par une première valeur prédéterminée de tension de mesure et une deuxième valeur prédéterminée de tension de mesure, et
- lorsque la tension aux bornes de la cellule est comprise entre la première valeur prédéterminée de tension de mesure et la deuxième valeur prédéterminée de tension de mesure :
- mesurer la valeur de l'intensité aux bornes de la cellule,
- mesurer la valeur de la température de la cellule,
- déterminer l'une des valeurs parmi :

○ l'acceptance de charge totale en décharge ($Q_{d-T}$) sur la plage de tension de mesure ;
○ l'acceptance de charge totale en charge ($Q_{c-T}$) sur la plage de tension de mesure ;
l'acceptance de charge totale en décharge ($Q_{d-T}$), respectivement en charge ($Q_{c-T}$), étant déterminée par la somme des valeurs $Q_d(t_k)$, respectivement $Q_c(t_k)$, entre la première valeur prédéterminée de tension de mesure et la deuxième valeur prédéterminée de tension de mesure,

la valeur $Q_d(t_k)$, respectivement $Q_c(t_k)$, étant la valeur de l'acceptance de charge en décharge, respectivement en charge, correspondant à la quantité d'Ampère-heure déchargée, respectivement chargée, de la cellule au temps k ($t_k$) ou durant un pas de temps égal à $t_k$; et
- déterminer l'état de santé (SOH) de la cellule sur la base d'une relation prédéterminée, sur la plage de tension de mesure, entre l'acceptance de charge totale en décharge ($Q_{d-T}$), respectivement en charge ($Q_{c-T}$), et l'état de santé (SOH) de la cellule,

**caractérisé en ce que** :

- Si la cellule est en décharge, alors la valeur $Q_d(t_k)$ est déterminée selon la formule $Q_d(t_k) = \alpha(T,C) * I(tk)$ ;
- Si la cellule est en charge, alors la valeur $Q_c(t_k)$ est déterminée selon la formule $Q_c(t_k) = \beta(T,C)* I(tk)$ ;
Avec $\alpha(T,C)$ et $\beta(T,C)$ des coefficients dont les valeurs dépendent au moins de la température (T) et éventuellement en outre de l'intensité (C), et qui sont préenregistrées dans une mémoire, I(tk) la valeur du courant au temps k ($t_k$) ou durant un pas de temps égal à $t_k$.

2. Procédé selon la revendication 1, dans lequel la variation de la tension en fonction de l'état de charge (SOC) de la cellule est connue, et dans lequel la plage de tension de mesure est définie, en outre, de sorte à respecter au moins l'un des critères suivants :

- la plage de tension de mesure est choisie de sorte que la variation de la tension en fonction de l'état de charge (SOC) de la cellule est inférieure à une valeur seuil prédéfinie,
- la plage de tension de mesure est comprise dans une plage représentative d'un état de charge (SOC) de la cellule compris entre 10% et 90%, et préférentiellement compris entre 45% et 55%, et
- la plage de tension de mesure est choisie dans une plage de tension traversée par la cellule dans le cadre de son application d'usage à une fréquence supérieure ou égale à une valeur seuil prédéterminée.

3. Procédé selon l'une quelconque des revendications précédentes, dans lequel dans la plage de tension de mesure, l'écart entre la première valeur prédéterminée de tension de mesure et la deuxième valeur prédéterminée de tension de mesure est compris entre 0,05V et 0,20V, et préférentiellement entre 0,05V et 0,10V.

4. Procédé selon l'une quelconque des revendications précédentes, comprenant en outre une étape d'essais, préalablement à l'étape de détermination de l'état de santé (SOH) de la cellule sur la base d'une relation prédéterminée, sur la plage de tension de mesure, entre l'acceptance de charge totale en décharge ($Q_{d-T}$), respectivement en charge ($Q_{c-T}$), et l'état de santé (SOH) de la cellule, lesdits essais étant mis en œuvre sur une cellule représentative pour déterminer ladite relation entre l'état de santé (SOH) de la cellule et l'acceptance de charge totale en décharge ($Q_{d-T}$), respectivement en charge ($Q_{c-T}$).

5. Procédé selon l'une quelconque des revendications précédentes, comprenant en outre une étape de calibration de la capacité totale de la cellule de batterie Li-ion, ladite cellule étant **caractérisée par** une capacité initiale $C_{tot\_ref}(t_0)$,

l'étape de calibration comprenant des étapes consistant à :

- détecter une phase de fin de charge, respectivement de décharge, et lors de la détection d'une phase de fin de charge, respectivement de décharge :
- recalibrer la capacité totale de la cellule comme étant $C_{tot\_ref}(t_k) = SOH* C_{tot\_ref}(t_0)$ ; et définir $C_r(t_k) = \tilde{C}_{tot\_ref}(t_k)$, respectivement $C_r(t_k) = 0$ ; et
- Définir les valeurs $Q_d(t_k) = Q_c(t_k) = 0$,

avec
$C_{tot\_ref}(t_0)$ : la valeur de la capacité de stockage totale de la cellule considérant une décharge complète dans les conditions de référence, au temps initial ($t_0$),

$C_{tot\_ref}$ ($t_k$) : la valeur de la capacité de stockage totale de la cellule considérant une décharge complète dans les conditions de référence, au temps k ($t_k$) ou durant un pas de temps égal à $t_k$,

$C_r$ ($t_k$) : la capacité stockée restante considérant une décharge complète dans les conditions de référence, au temps k ($t_k$) ou durant un pas de temps égal à $t_k$, et

SOH : la valeur de l'état de santé (SOH) déterminé de la cellule.

6. Procédé selon la revendication 5, comprenant en outre une étape de détermination de l'état de charge (SOC) de la cellule, par des étapes consistant à déterminer l'une des valeurs parmi :

○ la valeur $Q_d$ ($t_k$), la valeur de l'acceptance de charge correspondant à la quantité d'Ampère-heure déchargée de la cellule au temps k ($t_k$), ou durant un pas de temps égal à $t_k$ ; et calculer la valeur $C_r$ ($t_k$), la capacité stockée restante considérant une décharge complète dans les conditions de référence, au temps k ($t_k$) telle que $C_r$ ($t_k$) = $C_r$ ($t_{k-1}$) - $Q_d$ ($t_k$) ;
○ la valeur $Q_c$ ($t_k$), la valeur de l'acceptance de charge correspondant à la quantité d'Ampère-heure chargée au temps k ($t_k$), ou durant un pas de temps égal à $t_k$ ; et calculer la valeur $C_r$ ($t_k$) au temps k ($t_k$) telle que $C_r$ ($t_k$) = $C_r$ ($t_{k-1}$) + $Q_c$ ($t_k$).

7. Procédé selon l'une quelconque des revendications précédentes, comprenant en outre une étape d'initialisation, comprenant des étapes consistant à :

- déterminer la valeur d'une constante $C_{tot\_ref}$ ($t_0$), correspondant à la capacité de stockage totale de la cellule à un temps initial ($t_0$), considérant une décharge complète dans les conditions de référence ;
- initialiser la valeur d'une variable $C_{tot\_ref}$ ($t_k$), correspondant à la capacité de stockage totale de la cellule à un temps k ultérieur ($t_k$), considérant une décharge complète dans les conditions de référence, telle que $C_{tot\_ref}$ ($t_k$) = $C_{tot\_ref}$ ($t_0$) ;
- déterminer la valeur de l'état de charge (SOC) de la cellule ;
- initialiser la valeur d'une variable $C_r$ ($t_k$), correspondant à la capacité stockée restante au temps k ($t_k$), en fonction de la valeur de l'état de charge (SOC), telle que :

$C_r$ ($t_k$) = 0, si l'état de charge (SOC) déterminé est égal à 0% ;
$C_r$ ($t_k$) = $C_{tot\_ref}$ ($t_k$), si l'état de charge (SOC) déterminé est égal à 100% ; et
$C_r$ ($t_k$) = X, si l'état de charge (SOC) déterminé est égal à X/ $C_{tot\_ref}$ ($t_k$).

- Initialiser à 0 la valeur d'une variable $Q_d$ ($t_k$), correspondant à l'acceptance de charge en décharge de la cellule, et
- Initialiser à 0 la valeur d'une variable $Q_c$ ($t_k$), correspondant à l'acceptance de charge en charge de la cellule.

8. Procédé selon l'une quelconque des revendications précédentes, comprenant en outre des étapes consistant à :

- mesurer la valeur du courant (I) aux bornes de la cellule ;
- comparer la valeur du courant (I) mesurée à une valeur de référence (Iref) éventuellement non nulle ;
- déterminer le mode de charge de la cellule, tel que :

○ Si I < Iref, alors la cellule est en mode de décharge ;
○ Si I > Iref, alors la cellule est en mode de charge ;
○ Si I = Iref pendant une durée prédéterminée, alors la cellule est en mode neutre.

9. Procédé selon la revendication 8, comprenant en outre des étapes consistant à :

○ Si la cellule est en mode de décharge, alors déterminer la valeur $Q_d$ ($t_k$), et calculer la valeur $C_r$ ($t_k$) ;
○ Si la cellule est en mode de charge, alors déterminer la valeur $Q_c$ ($t_k$), et calculer la valeur $C_r$ ($t_k$).

10. Procédé selon la revendication 9, dans lequel :

- Si la cellule est en mode de décharge, alors la valeur $Q_d$ ($t_k$) est déterminée selon la formule $Q_d$ ($t_k$) = $\alpha$(T, C) * I(tk) ; et
- Si la cellule est en mode de charge, alors la valeur $Q_c$ ($t_k$) est déterminée selon la formule $Q_c$ ($t_k$) = $\beta$(T, C)* I(tk) ;

$\alpha$(T, C) et $\beta$(T, C) étant des coefficients dont les valeurs enregistrées dans une mémoire, dépendant au moins de la température (T) et éventuellement de l'intensité (C).

11. Procédé selon l'une quelconque des revendications précédentes, **caractérisé en ce qu'**il est mis en œuvre dans la plage de tension d'usage dans laquelle la cellule est destinée à être opérée, et qui est comprise entre une première valeur prédéterminée correspondant un état de charge (SOC) supérieur ou égal 10% ; et une deuxième valeur prédéterminée correspondant à un état de charge (SOC) inférieur ou égal à 90%.

12. Système de gestion de batterie, comprenant des moyens, parmi lesquels un processeur, adaptés pour la mise en œuvre du procédé selon l'une quelconque des revendications précédentes.

13. Programme d'ordinateur, comprenant des instructions de code de programme qui conduisent le système selon la revendication 12 à mettre en œuvre les étapes du procédé selon l'une quelconque des revendications 1 à 11 lorsque ledit programme est exécuté sur le processeur.

**Patentansprüche**

1. Verfahren zur Bestimmung des Gesundheitszustands (SOH) einer Li-Ionen-Batteriezelle, wobei die Zelle für den Betrieb in einem Betriebsspannungsbereich für eine bestimmte Anwendung vorgesehen ist, das Verfahren umfassend die folgenden Schritte:

- Festlegen eines Messspannungsbereichs, der innerhalb des Betriebsspannungsbereichs liegt und durch einen ersten vorbestimmten Messspannungswert und einen zweiten vorbestimmten Messspannungswert begrenzt ist, und
- wenn die Spannung an den Klemmen der Zelle zwischen dem ersten vorbestimmten Messspannungswert und dem zweiten vorbestimmten Messspannungswert liegt:
- Messen des Intensitätswerts an den Klemmen der Zelle,
- Messen des Temperaturwerts der Zelle,
- Bestimmen eines der folgenden Werte:

∘ der Gesamtladungsaufnahme bei Entladung ($Q_{d-T}$) über den Messspannungsbereich;
∘ der Gesamtladungsaufnahme bei Ladung ($Q_{c-T}$) über den Messspannungsbereich; wobei die Gesamtladungsaufnahme bei Entladung ($Q_{d-T}$) bzw. bei Ladung ($Q_{c-T}$) durch die Summe der Werte $Q_d$ ($t_k$) bzw. $Q_c$ ($t_k$) zwischen dem ersten vorbestimmten Messspannungswert und dem zweiten vorbestimmten Messspannungswert bestimmt wird, wobei der Wert $Q_d$ ($t_k$) bzw. $Q_c$ ($t_k$) der Wert der Ladungsaufnahme bei Entladung bzw. bei Ladung ist, der der entladenen bzw. geladenen Amperestundenzahl der Zelle

zum Zeitpunkt k ($t_k$) oder während eines Zeitabschnitts gleich $t_k$ entspricht; und

- Bestimmen des Gesundheitszustands (SOH) der Zelle auf der Grundlage einer vorbestimmten Beziehung über den Messspannungsbereich zwischen der Gesamtladungsaufnahme bei Entladung ($Q_{d-T}$) bzw. bei Ladung ($Q_{c-T}$) und dem Gesundheitszustand (SOH) der Zelle, **dadurch gekennzeichnet, dass**:
- wenn die Zelle entladen ist, der Wert $Q_d$ ($t_k$) nach der Formel $Q_d$ ($t_k$) = α(T,C) * I($t_k$) bestimmt wird;
- wenn die Zelle geladen ist, der Wert $Q_c$ ($t_k$) nach der Formel $Q_c$ ($t_k$) = β(T,C)* I($t_k$) bestimmt wird;

wobei α(T,C) und β(T,C) Koeffizienten sind, deren Werte mindestens von der Temperatur (T) und gegebenenfalls zusätzlich von der Intensität (C) abhängen und die in einem Speicher vorab gespeichert sind, I($t_k$) der Wert des Stroms zum Zeitpunkt k ($t_k$) oder während eines Zeitabschnitts gleich $t_k$ ist.

2. Verfahren nach Anspruch 1, wobei die Änderung der Spannung in Abhängigkeit von dem Ladezustand (SOC) der Zelle bekannt ist und wobei der Messspannungsbereich zusätzlich so festgelegt ist, dass mindestens eines der folgenden Kriterien erfüllt ist:

- der Messspannungsbereich ist so gewählt, dass die Änderung der Spannung in Abhängigkeit von dem Ladezustand (SOC) der Zelle unter einem vorgegebenen Schwellenwert liegt,
- der Messspannungsbereich liegt in einem Bereich, der für einen Ladezustand (SOC) der Zelle zwischen 10 % und 90 %, vorzugsweise zwischen 45 % und 55 %, repräsentativ ist, und
- der Messspannungsbereich ist in einem Spannungsbereich gewählt, den die Zelle im Rahmen ihrer bestimmungsgemäßen Verwendung bei einer Frequenz durchläuft, die größer oder gleich einem vorbestimmten Schwellenwert ist.

3. Verfahren nach einem der vorhergehenden Ansprüche, wobei in dem Messspannungsbereich die Abweichung zwischen dem ersten vorbestimmten Messspannungswert und dem zweiten vorbestimmten Messspannungswert zwischen 0,05 V und 0,20 V und vorzugsweise zwischen 0,05 V und 0,10 V liegt.

4. Verfahren nach einem der vorhergehenden Ansprüche, das zusätzlich einen Testschritt vor dem Schritt der Bestimmung des Gesundheitszustands (SOH) der Zelle auf der Grundlage einer vorbestimmten Beziehung in dem Messspannungsbereich zwischen der Gesamtladungsaufnahme bei Entladung ($Q_{d-T}$) bzw. bei Ladung ($Q_{c-T}$) und dem Gesundheitszustand (SOH) der Zelle umfasst, wobei die Tests an einer repräsentativen Zelle durchgeführt werden, um die Beziehung zwischen dem Gesundheitszustand (SOH) der Zelle und der Gesamtladungsaufnahme bei Entladung ($Q_{d-T}$) bzw. bei Ladung ($Q_{c-T}$) zu bestimmen.

5. Verfahren nach einem der vorhergehenden Ansprüche, das zusätzlich einen Schritt zum Kalibrieren der Gesamtkapazität der Li-Ionen-Batteriezelle umfasst, wobei die Zelle durch eine Anfangskapazität $C_{tot\_ref}$ ($t_0$) gekennzeichnet ist,

   wobei der Kalibrierschritt die folgenden Schritte umfasst:

   - Erfassen einer Ladeendphase bzw. Entladeendphase und bei Erfassung einer Ladeendphase bzw. Entladeendphase:
   - Neukalibrieren der Gesamtkapazität der Zelle als $C_{tot\_ref}$ ($t_k$)=SOH* $C_{tot\_ref}$ ($t_0$); und Definieren von $G_r$ ($t_k$)= $C_{tot\_ref}$ ($t_k$), bzw. $C_r$ ($t_k$)= 0; und
   - Definieren der Werte $Q_d$ ($t_k$) = $Q_c$ ($t_k$) = 0,

   mit

   $C_{tot\_ref}$ ($t_0$): Wert der Gesamtspeicherkapazität der Zelle unter Berücksichtigung einer vollständigen Entladung unter Referenzbedingungen zum Anfangszeitpunkt ($t_0$),
   $C_{tot\_ref}$ ($t_k$): Wert der Gesamtkapazität der Zelle unter Berücksichtigung einer vollständigen Entladung unter Referenzbedingungen zum Zeitpunkt k ($t_k$) oder während eines Zeitabschnitts, der $t_k$ entspricht,
   $C_r$ ($t_k$): verbleibende gespeicherte Kapazität unter Berücksichtigung einer vollständigen Entladung unter Referenzbedingungen zum Zeitpunkt k ($t_k$) oder während eines Zeitabschnitts, der $t_k$ entspricht, und
   SOH: Wert des bestimmten Gesundheitszustands (SOH) der Zelle.

6. Verfahren nach Anspruch 5, das zusätzlich einen Schritt zur Bestimmung des Ladezustands (SOC) der Zelle umfasst, durch Schritte, die darin bestehen, einen der folgenden Werte zu bestimmen:

   ∘ den Wert $Q_d$ ($t_k$) als Wert der Ladungsaufnahme, der der aus der Zelle zum Zeitpunkt k ($t_k$) entladenen Amperestundenzahl entspricht, oder während eines Zeitabschnitts, der gleich $t_k$ ist; und Berechnen des Wertes $C_r$ ($t_k$), der unter Berücksichtigung einer vollständigen Entladung unter den Referenzbedingungen zum Zeitpunkt k ($t_k$) verbleibenden gespeicherten Kapazität, so dass $C_r$ ($t_k$) = $C_r$ ($t_{k-1}$) - $Q_d$ ($t_k$),
   ∘ den Wert $Q_c$ ($t_k$), den Wert der Ladungsaufnahme, der der zum Zeitpunkt k ($t_k$) oder während eines Zeitabschnitts gleich $t_k$ geladenen Amperestundenzahl entspricht; und Berechnen des Werts $C_r$ ($t_k$) zum Zeitpunkt k ($t_k$), sodass $C_r$ ($t_k$) = $C_r$ ($t_{k-1}$) + $Q_c$ ($t_k$).

7. Verfahren nach einem der vorhergehenden Ansprüche, das zusätzlich einen Initialisierungsschritt umfasst, umfassend die folgenden Schritte:

   - Bestimmen des Wertes einer Konstante $C_{tot\_ref}$ ($t_0$), die der Gesamtspeicherkapazität der Zelle zu einem Anfangszeitpunkt ($t_0$) unter Berücksichtigung einer vollständigen Entladung unter Referenzbedingungen entspricht;
   - Initialisieren des Werts einer Variablen $C_{tot\_ref}$ ($t_k$), die der Gesamtspeicherkapazität der Zelle zu einem späteren Zeitpunkt k ($t_k$), unter Berücksichtigung einer vollständigen Entladung unter Referenzbedingungen entspricht, so dass $C_{tot\_ref}$ ($t_k$) = $C_{tot\_ref}$ ($t_0$);
   - Bestimmen des Werts des Ladezustands (SOC) der Zelle;
   - Initialisieren des Werts einer Variablen $C_r$ ($t_k$), die der zum Zeitpunkt k ($t_k$) verbleibenden gespeicherten Kapazität entspricht, in Abhängigkeit von dem Wert des Ladezustands (SOC), wie folgt:

   $C_r$ ($t_k$) = 0, wenn der bestimmte Ladezustand (SOC) 0 % beträgt;
   $C_r$ ($t_k$) = $C_{tot\_ref}$ ($t_k$), wenn der bestimmte Ladezustand (SOC) gleich 100 % ist; und
   $C_r$ ($t_k$) = X, wenn der bestimmte Ladezustand (SOC) gleich X/ $C_{tot\_ref}$ ($t_k$) ist.

   - Initialisieren des Werts einer Variablen $Q_d$ ($t_k$), die der Ladungsaufnahme bei Entladung der Zelle entspricht, auf 0 und
   - Initialisieren des Werts einer Variablen $Q_c$ ($t_k$), die der Ladungsaufnahme bei Ladung der Zelle entspricht, auf 0.

8. Verfahren nach einem der vorhergehenden Ansprüche, das außerdem die folgenden Schritte umfasst:

   - Messen des Stromwerts (I) an den Klemmen der Zelle;
   - Vergleichen des gemessenen Stromwerts (I) mit einem Referenzwert (Iref), der gegebenenfalls ungleich null ist;
   - Bestimmen des Ladungsmodus der Zelle, sodass:

   ∘ bei I < Iref sich die Zelle in dem Entladungsmodus befindet;
   ∘ bei I > Iref sich die Zelle in dem Ladungsmodus befindet;

∘ bei I = Iref während einer vorbestimmten Zeitdauer sich die Zelle in dem neutralen Modus befindet.

9. Verfahren nach Anspruch 8, das außerdem die folgenden Schritte umfasst:

∘ wenn sich die Zelle in dem Entladungsmodus befindet, dann Bestimmen des Werts $Q_d(t_k)$ und Berechnen des Werts $C_r(t_k)$;
∘ wenn sich die Zelle in dem Ladungsmodus befindet, dann Bestimmen des Werts $Q_c(t_k)$ und Berechnen des Werts $C_r(t_k)$.

10. Verfahren nach Anspruch 9, wobei:

- der Wert $Q_d(t_k)$ nach der Formel $Q_d(t_k) = \alpha(T, C) * I(t_k)$ bestimmt wird, wenn sich die Zelle in dem Entladungsmodus befindet; und
- der Wert $Q_c(t_k)$ nach der Formel $Q_c(t_k) = \beta(T, C) * I(t_k$ bestimmt wird, wenn sich die Zelle in dem Ladungsmodus befindet;

$\alpha(T, C)$ und $\beta(T, C)$ Koeffizienten sind, deren Werte in einem Speicher gespeichert sind und mindestens von der Temperatur (T) und gegebenenfalls von der Intensität (C) abhängen.

11. Verfahren nach einem der vorhergehenden Ansprüche, **dadurch gekennzeichnet, dass** es in dem Betriebsspannungsbereich durchgeführt wird, in dem die Zelle betrieben werden soll und der zwischen einem ersten vorbestimmten Wert, der einem Ladezustand (SOC) von größer oder gleich 10 % entspricht, und einem zweiten vorbestimmten Wert, der einem Ladezustand (SOC) von kleiner oder gleich 90 % entspricht, liegt.

12. Batteriemanagementsystem, das Mittel, darunter einen Prozessor, umfasst, die zur Durchführung des Verfahrens nach einem der vorhergehenden Ansprüche geeignet sind.

13. Computerprogramm, das Programmcodeanweisungen umfasst, die das System nach Anspruch 12 dazu veranlassen, die Schritte des Verfahrens nach einem der Ansprüche 1 bis 11 durchzuführen, wenn das Programm auf dem Prozessor ausgeführt wird.

**Claims**

1. Method for determining the state of health (SOH) of a Li-ion battery cell, the cell being intended to be operated in a usage voltage range for a usage application, the method comprising steps consisting in:

- defining a measurement voltage range comprised in the usage voltage range and delimited by a first predetermined measurement voltage value and a second predetermined measurement voltage value, and
- when the voltage across the terminals of the cell is comprised between the first predetermined measurement voltage value and the second predetermined measurement voltage value:
- measuring the value of the current across the terminals of the cell,
- measuring the value of the temperature of the cell,
- determining one of the values among:

∘ the total charge acceptance when discharging ($Q_{d-T}$) over the measurement voltage range;
∘ the total charge acceptance when charging ($Q_{c-T}$) over the measurement voltage range;
the total charge acceptance when discharging ($O_{d-T}$), respectively when charging ($Q_{c-T}$), being determined by the sum of the values $Q_d(t_k)$, respectively $Q_c(t_k)$, between the first predetermined measurement voltage value and the second predetermined measurement voltage value,
the value $Q_d(t_k)$, respectively $Q_c(t_k)$, being the value of the charge acceptance when discharging, respectively when charging, corresponding to the Ampere-hour quantity discharged, respectively charged, of the cell at time k ($t_k$) or during a time step equal to $t_k$; and

- determining the state of health (SOH) of the cell on the basis of a predetermined relationship, over the measurement voltage range, between the total charge acceptance when discharging ($Q_{D-T}$), respectively when charging ($Q_{c-T}$), and the state of health (SOH) of the cell, **characterized in that**:
- **If** the cell is discharging, then the value $Q_d(t_k)$ is determined according to the formula $Q_d(t_k) = \alpha(T,C) * I(t_k)$;
- If the cell is charging, then the value $Q_c(t_k)$ is determined according to the formula $Q_c(t_k) = \beta(T,C) * I(t_k)$;

Where $\alpha(T,C)$ and $\beta(T,C)$ are coefficients the values of which depend at least on the temperature (T) and optionally also on the current (C) and which are prerecorded in a memory, and $I(t_k)$ is the value of the current at time k ($t_k$) or during a time step equal to $t_k$.

2. Method according to Claim 1, wherein the change in the voltage as a function of the state of charge (SOC) of the cell is known, and wherein the measurement voltage range is further defined so as to satisfy at least one of the following criteria:

- the measurement voltage range is chosen so that the change in the voltage as a function of the state of charge (SOC) of the cell is below a predefined threshold value,
- the measurement voltage range is comprised in a range representative of a state of charge (SOC) of the cell comprised between 10% and 90%, and preferentially comprised between 45% and 55%, and
- the measurement voltage range is chosen in a voltage range spanned by the cell as part of its usage application at a frequency of greater than or equal to a predetermined threshold value.

3. Method according to either one of the preceding claims, wherein in the measurement voltage range, the difference between the first predetermined measurement voltage value and the second predetermined measurement voltage value is comprised between 0.05 V and 0.20 V, and preferentially between 0.05 V and 0.10 V.

4. Method according to any one of the preceding claims, further comprising a step of testing, prior to the step of determining the state of health (SOH) of the cell on the basis of a predetermined relationship, over the measurement voltage range, between the total charge acceptance when discharging ($Q_{d-T}$), respectively when charging ($Q_{c-T}$), and the state of health (SOH) of the cell, said tests being carried out on a representative cell to determine said relationship between the state of health (SOH) of the cell and the total charge acceptance when discharging ($Q_{d-T}$), respectively when charging ($Q_{c-T}$).

5. Method according to any one of the preceding claims, further comprising a step of calibrating the total capacity of the Li-ion battery cell, said cell being **characterized by** an initial capacity $C_{tot\_ref}$ ($t_0$),

the calibration step comprising steps consisting in:

- detecting an end-of-charging phase, respectively an end-of-discharging phase, and when an end-of-charging phase, respectively an end-of-discharging phase, has been detected:

- recalibrating the total capacity of the cell as being $C_{tot\_ref}$ ($t_k$)=SOH* $C_{tot\_ref}$ ($t_0$); and defining $C_r$ ($t_k$)= $C_{tot\_ref}$ ($t_k$), respectively $C_r$ ($t_k$)= 0; and

- defining the values $Q_d$ ($t_k$) = $Q_c$ ($t_k$) = 0,

where

$C_{tot\_ref}$ ($t_0$) is the value of the total storage capacity of the cell considering complete discharge under reference conditions, at initial time ($t_0$),

$C_{tot\_ref}$ ($t_k$) is the value of the total storage capacity of the cell considering complete discharge under reference conditions, at time k ($t_k$) or during a time step equal to $t_k$,

$C_r$ ($t_k$) is the remaining stored capacity considering complete discharge under reference conditions, at time k ($t_k$) or during a time step equal to $t_k$, and

SOH is the value of the determined state of health (SOH) of the cell.

6. Method according to Claim 5, further comprising a step of determining the state of charge (SOC) of the cell by steps consisting in determining one of the values among:

○ the value $Q_d$ ($t_k$), the value of the charge acceptance corresponding to the Ampere-hour quantity discharged from the cell at time k ($t_k$), or during a time step equal to $t_k$; and calculating the value $C_r$ ($t_k$), the remaining stored capacity considering complete discharge under reference conditions, at time k ($t_k$) such that $C_r$ ($t_k$) = $C_r$ ($t_{k-1}$) - $Q_d$ ($t_k$);
○ the value $Q_c$ ($t_k$), the value of the charge acceptance corresponding to the Ampere-hour quantity charged at time k ($t_k$), or during a time step equal to $t_k$; and calculating the value $C_r$ ($t_k$) at time k ($t_k$) such that $C_r$ ($t_k$) = $C_r$ ($t_{k-1}$) + $Q_c$ ($t_k$).

7. Method according to any one of the preceding claims, further comprising an initialization step, comprising steps consisting in:

- determining the value of a constant $C_{tot\_ref}$ ($t_0$), corresponding to the total storage capacity of the cell at an initial time ($t_0$), considering complete discharge under reference conditions;
- initializing the value of a variable $C_{tot\_ref}$ ($t_k$), corresponding to the total storage capacity of the cell at a later time k ($t_k$), considering complete discharge under reference conditions, such that $C_{tot\_ref}$ ($t_k$) = $C_{tot\_ref}$ ($t_0$);
- determining the value of the state of charge (SOC) of the cell;
- initializing the value of a variable $C_r$ ($t_k$), corresponding to the remaining stored capacity at time k ($t_k$), as a function of the value of the state of charge (SOC), such that:

$C_r$ ($t_k$) = 0, if the determined state of charge (SOC) is equal to 0%;
$C_r(t_k) = C_{tot\_ref}(t_k)$, if the determined state of charge (SOC) is equal to 100%; and
$C_r(t_k) = X$, if the determined state of charge (SOC) is equal to $X/C_{tot\_ref}(t_k)$,

- initializing to 0 the value of a variable $Q_d(t_k)$, corresponding to the charge acceptance of the cell when discharging, and
- initializing to 0 the value of a variable $Q_c(t_k)$, corresponding to the charge acceptance of the cell when charging.

8. Method according to any one of the preceding claims, further comprising steps consisting in:

   - measuring the value of the current (I) across the terminals of the cell;
   - comparing the measured value of the current (I) with an optionally non-zero reference value (Iref);
   - determining the charge mode of the cell, such that:

     ◦ If I < Iref, then the cell is in discharge mode;
     ◦ If I > Iref, then the cell is in charge mode;
     ◦ If I = Iref for a predetermined duration, then the cell is in neutral mode.

9. Method according to Claim 8, further comprising steps consisting in:

   ◦ If the cell is in discharge mode, then determining the value $Q_d(t_k)$, and calculating the value $C_r(t_k)$,
   ◦ If the cell is in charge mode, then determining the value $Q_c(t_k)$, and calculating the value $C_r(t_k)$.

10. Method according to Claim 9, wherein:

    - If the cell is in discharge mode, then the value $Q_d(t_k)$ is determined according to the formula $Q_d(t_k) = \alpha(T, C) * I(t_k)$; and
    - If the cell is in charge mode, then the value $Q_c(t_k)$ is determined according to the formula $Q_c(t_k) = \beta(T, C) * I(t_k)$;

    $\alpha(T, C)$ and $\beta(T, C)$ being coefficients the values of which are recorded in a memory and which depend at least on the temperature (T) and optionally on the current (C).

11. Method according to any one of the preceding claims, **characterized in that** it is carried out in the usage voltage range in which the cell is intended to be operated and which is comprised between a first predetermined value corresponding to a state of charge (SOC) of greater than or equal to 10% and a second predetermined value corresponding to a state of charge (SOC) of less than or equal to 90%.

12. Battery management system, comprising means, including a processor, which are designed to carry out the method according to any one of the preceding claims.

13. Computer program, comprising program code instructions which cause the system according to Claim 12 to carry out the steps of the method according to any one of Claims 1 to 11 when said program is executed on the processor.

**EP 4 390 424 B1**

[Fig. 1]

[Fig. 2]

[Fig. 3]

[Fig. 4]

[Fig. 5]

[Fig. 6]

**EP 4 390 424 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 3080625 B1
- EP 3080624 B1
- US 2014009123 A1